# EUROPEAN PATENT APPLICATION

(11) **EP 4 808 298 A1**
(43) Date of publication of application: **16.09.2026**
(21) Application number: 26164630.1
(22) Date of filing: 13.03.2026
(51) Int. Cl.: H05K 7/14

(54) **BUSBAR CONNECTOR WITH INTEGRATED POWER MANAGEMENT**

(30) Priority: 14.03.2025 US 202519080003
(71) Applicant: Nvidia Corporation, Santa Clara, CA 95051 (US)
(72) Inventor: MENTOVICH, Elad, Santa Clara, 95051 (US); NORTON, John, Santa Clara, 95051 (US); GORLA, Gabriele, Santa Clara, 95051 (US); ALBRIGHT, Ryan, Santa Clara, 95051 (US)
(74) Representative: Mathys & Squire

(57) **Abstract**

According to an aspect of the present disclosure, a power management module configured for powering a server tray is provided. In an example embodiment, the power management module includes a housing; a busbar connector extending from a first side of the housing; power management circuitry; and a tray connector accessible via a second side of the housing. The power management circuitry includes at least one fuse component, and is in electrical communication with the busbar connector. The tray connector is configured to provide electrical power to the server tray.

## Description

### BACKGROUND

In datacenters, server trays hosting computing resources, switches, and/or the like tend to be mounted within server racks. A server rack includes a busbar configured to delivery electrical power to the server trays. For example, the server trays comprise a busbar connector configured to electrically couple components of the server tray to the busbar. The electrical power received at the busbar connector is carried by cabling over the modules of the server tray to a power distribution board located on the printed circuit board (PCB) and/or motherboard of the tray. The power distribution board then distributes electrical power to the modules of the tray. The power distribution board may need to condition high voltage and/or current electrical signals and tends to include components that may fail during operation of the tray. However, the integrated nature of the power distribution board makes replacement the power distribution board difficult to service when the components do fail. Therefore, there is a need in the art for server tray power management systems that enable efficient servicing of the power management system.

### GENERAL DESCRIPTION

The invention is defined by the claims. In order to illustrate the invention, aspects and embodiments which may or may not fall within the scope of the claims are described herein.

As artificial intelligence and/or machine learning use increases, the amount of information being processed by datacenters and communicated between large clusters of computing resources (e.g., graphical processing units (GPUs), central processing units (CPUs), data processing units (DPUs), and/or the like) is also increasing. The computing resources of datacenters are generally hosted by server trays mounted within server racks. In order to power the computing resources, a server tray receives electrical power from a busbar. For example, a server tray may include a busbar connector configured for interfacing with the busbar to receive electrical power therefrom. In various embodiments, a server tray includes a power management module that is integrated with the busbar connector. The integrated power management module may condition the electrical power and distribute the electrical power to various computing resources, switches, fans configured for air cooling, etc. of the server tray. By integrating the power management module with the busbar connector, rather than having a centrally located power distribution board that is integrated with the PCB and/or motherboard of the server tray, enables the power management module to be a field-replaceable unit (FRU).

In at least one example embodiment, a datacenter corresponds to a collection of network devices, such as network switches (e.g., Ethernet switches, IP routers, multiservice platforms, various transmission network elements, legacy communication equipment, or in any other suitable communication system) connected with a collection of L1 domains such as servers or compute nodes. A switch fabric serves to transfer the data between the switch ports. A switch fabric comprises one or more interconnect circuits, which may be arranged in various switch fabric architectures, e.g., m*m crossbar, Banyan, Benes, Omega, Clos, multi-plane, STS, TST, shared memory, buffered crossbar, any other suitable blocking or non-blocking architecture, or any applicable mixed architecture thereof. A switch fabric is realized in typical embodiments by hardware, which may comprise Field-Programmable Gate Arrays (FPGAs) and/or Application-Specific Integrated Circuits (ASICs), and in some implementations also bus interconnects. The datacenter may adhere to a networking topology (e.g., a hierarchal networking topology), such as a fat tree topology, a Slim Fly topology, a Dragonfly topology, and/or the like. The datacenter routes traffic amongst the network switches and L1 domains (e.g., servers, compute nodes, and/or the like) therein, and at least one layer of the topology in the datacenter is coupled to the communication network to allow networking traffic to flow between the datacenter and the network device(s).

In some embodiments, optical interconnects include transceivers used to connect network-connected devices (e.g., remote client switches, network adapters such as Network Interface controllers (NICs) and Host Channel Adapters (HCAs), Smart-NICs (NICs having embedded CPUs), network-enabled Graphics Processing Units (GPUs), and the like). The terms "network-connected device" and "network device" are used interchangeably herein. In certain embodiments, an optical interconnect includes a substrate, one or more optical waveguides, one or more first micro-lenses, one or more second micro-lenses, and first and second mechanical fixtures.

A "node" as described herein may refer to a network switch to which a plurality of computer processing units (CPUs), graphical processing units (GPUs), data processing units (DPUs), parallel processing units (PPUs), quantum processing units (QPUs), and/or memory media are connected in an arbitrary number. The network switch may communicate with other network switches of the same kind to which the same processing and memory units may be connected. However, in other implementations, "node" may also refer to a processor which may be responsible for communication with all other nodes in the network or subnetwork.

QPUs are configured to perform one or more operations associated with a quantum algorithm. In some embodiments, each of the one or more QPUs may include a plurality of qubits and the one or more QPUs may be in communication with each other via a quantum channel. In some embodiments, each of the plurality of qubits may include local qubits, global qubits, and/or synchronization qubits. In some embodiments, the local qubits of each QPU may be configured to perform the one or more operations associated with the quantum algorithm on the QPU that the local qubits are associated with.

An "optical fiber" as described herein can refer to a single optical fiber (e.g., including a core and a cladding) to provide unidirectional optical communication, can refer to a bidirectional pair of optical fibers (e.g., each including a core and a cladding) to provide both transmit and receive communications in an optical network, or can refer to a multicore fiber, such that a single cladding could encapsulate a plurality of single-mode cores. Optical fibers can extend contiguously and uninterrupted between node or send/receive pairs (e.g., via pass-through connections) or include two or more fibers connected via fiber-to-fiber connections such that the fibers function or perform as a single fiber.

Silicon Photonics (SiP) is a technology that enables optical systems to be manufactured using silicon processes with silicon as the optical medium. Various optical components, such as interconnects and signal processing components, may be fabricated and integrated in a single SiP device. Some SiP devices are fabricated on a silica substrate or over a silica layer on a silicon substrate, a technology that is often referred to as Silicon on Insulator (SOI). In certain optical systems, a SiP device is attached to an external device to facilitate optical communications. However, it is generally difficult to accurately align light signals on the SiP with an external device that receives the light.

In certain optical systems, a SiP device is attached to an external device to facilitate optical communications. For example, the system includes one or more waveguides that carry light signals to and/or from optical chips. Examples of optical chips that can be included on the device include, but are not limited to, one or more components selected from a group consisting of facets through which light signals can enter and/or exit a waveguide, entry/exit ports through which light signals can enter and/or exit a waveguide from above or below the device, multiplexers for combining multiple light signals onto a single waveguide, demultiplexers for separating multiple light signals such that different light signals are received on different waveguides, optical couplers, optical switches, lasers that act as a source of a light signal, amplifiers for amplifying the intensity of a light signal, attenuators for attenuating the intensity of a light signal, modulators for modulating a signal onto a light signal, modulators that convert a light signal to an electrical signal, and vias that provide an optical pathway for a light signal traveling through the device. Additionally, the device can optionally, include electrical components. For instance, the device can include electrical connections for applying a potential or current to a waveguide, controlling active optical components, such as modulators, for example, and/or for controlling other components on the optical device.

According to an aspect of the present disclosure, a power management module configured for powering a server tray is provided. In an example embodiment, the power management module includes a housing; a busbar connector extending from a first side of the housing; power management circuitry comprising at least one fuse component, the power management circuit in electrical communication with the busbar connector; and a tray connector accessible via a second side of the housing, wherein the tray connector is configured to provide electrical power to the server tray. The flexible bus bar connector configuration allows for a tight package and the integration of power components at the point of load. This configuration reduces power losses and improves accessibility, eliminating the need for bulky cables and improving overall efficiency.

In an example embodiment, the tray connector comprises at least one output power pin configured to interface with a power management circuit of a tray.

In an example embodiment, the power management circuitry comprises at least two parallel power conditioning portions.

In an example embodiment, the at least one fuse comprises at least two fuses and each parallel power conditioning portion of the at least two parallel power conditioning portions comprises a hotswap controller and a plurality of field effect transistors (FETs).

In an example embodiment, each of the plurality of FETs of the parallel power conditioning portion are configured to receive a first input from a fuse of the at least two fuses and a second input from the hotswap controller and configured to provide an output provided to an output power pin of the tray connector.

In an example embodiment, the hotswap controller is configured to control a time evolution of electrical power passing through the plurality of FETs.

In an example embodiment, the hotswap controller comprises one or more metal-oxide-semiconductor field effect transistors (MOSFETs).

In an example embodiment, wherein the power management circuitry comprises at last one of GaN or diamond-based circuitry to enable a small form factor with favorable heat dissipation properties. The use of advanced semiconductor components enables to handle high power requirements within a compact space.

According to another aspect, a server tray is provided. In an example embodiment, the server tray includes one or more circuit modules; and a power management module. The power management module includes a housing; a busbar connector extending from a first side of the housing; power management circuitry; and a tray connector accessible via a second side of the housing. The power management circuitry includes at least one fuse component and the power management circuit in electrical communication with the busbar connector. The tray connector is configured to provide electrical power to the server tray. For example, the one or more circuit modules are powered by the power management module.

In an example embodiment, the server tray further includes a tray component, wherein the one or more circuit modules are hosted by the tray component and the housing of the power management module is secured to the tray component.

In an example embodiment, at least a portion of the power management module is configured to flex with respect to a remainder of the server tray such that, when the busbar connector is coupled into electrical communication with a busbar, flexing of the at least a portion of the power management module with respect to the remainder of the server tray prevents the busbar connector from abrading the busbar.

In an example embodiment, the tray connector comprises at least one output power pin configured to interface with a power management circuit of the server tray.

In an example embodiment, the at least one output power pin is in floating physical contact with a contact of the power management circuit of the server tray.

In an example embodiment, the power management circuitry comprises at least two parallel power conditioning portions which are each configured to power respective subsets of the one or more circuit modules.

In an example embodiment, the at least one fuse comprises at least two fuses and each parallel power conditioning portion of the at least two parallel power conditioning portions comprises a hotswap controller and a plurality of field effect transistors (FETs).

In an example embodiment, each of the plurality of FETs of the parallel power conditioning portion are configured to receive a first input from a fuse of the at least two fuses and a second input from the hotswap controller and configured to provide an output provided to an output power pin of the tray connector.

In an example embodiment, the hotswap controller is configured to control a time evolution of electrical power passing through the plurality of FETs.

In an example embodiment, the hotswap controller comprises one or more metal-oxide-semiconductor field effect transistors (MOSFETs).

In an example embodiment, the power management circuitry comprises at last one of GaN or diamond-based circuitry.

In an example embodiment, the circuit modules include one or more a CPU, GPU, DPU, QPU, PPU, or switch
According to another aspect, a datacenter is provided. In an example embodiment, the datacenter comprises one or more server trays. At least one server tray of the one or more one or more server trays includes one or more circuit modules and a power management module. The power management modules includes a housing; a busbar connector extending from a first side of the housing; power management circuitry; and a tray connector accessible via a second side of the housing. The power management circuitry includes at least one fuse component and the power management circuit in electrical communication with the busbar connector. The tray connector is configured to provide electrical power to the server tray. For example, the one or more circuit modules are powered by the power management module.

Any feature of one aspect or embodiment may be applied to other aspects or embodiments, in any appropriate combination. In particular, any feature of a method aspect or embodiment may be applied to an apparatus aspect or embodiment, and vice versa.

### BRIEF DESCRIPTION OF THE SEVERAL VIEWS OF THE DRAWINGS

Reference will now be made to the accompanying drawings, which are not necessarily drawn to scale, and wherein:
Figure 1 provides a schematic top view of an example server tray, in accordance with certain embodiments;
Figure 2 provides a schematic illustration of an example datacenter including at least one tray mounted within a server rack, according to certain embodiments;
Figure 3 provides an exploded perspective view of a power management module, in accordance with certain embodiments;
Figure 4 provides a front perspective view of a power management module, in accordance with certain embodiments;
Figure 5 provides a perspective bottom view of a power management module, in accordance with certain embodiments;
Figure 6 provides a circuit diagram of example power management circuitry, in accordance with certain embodiments;
Figure 7 provides a perspective view illustrating how a power management module is secured to a server tray, in accordance with certain embodiments;
Figure 8 provides a block diagram of an example system that may include a datacenter and/or one or more trays according to certain embodiments;
Figure 9 provides a schematic diagram of an example datacenter that may include one or more trays according to certain embodiments;
Figures 10A and 10B illustrate a top view and a perspective view, respectively, of a transceiver module operatively coupled to a network adapter, in accordance with an embodiment of the disclosure.
Figure 11 provides a block diagram that schematically illustrates a computing system that may include one or more trays of various embodiments;
Figure 12 illustrates an example computing environment that may include one or more trays, in accordance with at least one embodiment;
Figure 13 illustrates another example computer system that may include one or more trays, according to at least one embodiment; and
Figure 14 is a block diagram that schematically illustrates a co-packaged Networking Device, in accordance with an embodiment that is disclosed herein.

### DETAILED DESCRIPTION

The present disclosure more fully describes various embodiments with reference to the accompanying drawings. It should be understood that some, but not all embodiments are shown and described herein. Indeed, the embodiments may take many different forms, and accordingly this disclosure should not be construed as limited to the embodiments set forth herein. Rather, these embodiments are provided so that this disclosure will satisfy applicable legal requirements. Like numbers refer to like elements throughout.

In datacenters, server trays hosting computing resources, switches, and/or the like tend to be mounted within server racks. A server rack includes a busbar configured to delivery electrical power to the server trays. For example, the server trays comprise a busbar connector configured to electrically couple components of the server tray to the busbar. Conventionally, electrical power received at the busbar connector is carried by cabling over the modules of the server tray to a power distribution board located on the printed circuit board (PCB) and/or motherboard of the tray. The power distribution board then distributes electrical power to the modules of the tray. The power distribution board is configured to condition the high voltage and/or current electrical power provided by the busbar. However, the power distribution board generally includes components that may fail and/or suffer damage from conditioning the high voltage and/or current electrical power. Thus, the power distribution board includes components that may fail during operation of the server tray. Because the power distribution board is integrated into PCB and/or motherboard of the server tray and located in the center of the server tray, servicing and/or replacing the power distribution board is difficult and generally cannot be performed by a field technician. Therefore, technical problems exist regarding reliably distributing power to modules of a server tray and/or servicing the power distribution board of a server tray.

Various embodiments provide technical solutions to these technical problems. Various embodiments provide a power management module that includes the busbar connector. For example, the busbar connector extends from a first side of a housing of the power management module and a tray connector extends from a second side of the housing. The housing houses power management circuitry configured to condition electrical power received from the busbar (e.g., via the busbar connector) and distribute and/or provide the conditioned electrical power to the power distribution circuitry of the server tray. Thus, the power management circuit is separate from the PCB and/or motherboard of the server tray. In various embodiments, the power management module is configured to be secured (e.g., via mechanical fasteners and/or the like) to an exterior surface of a tray component of a server tray. This enables the power management module to be easily removed, serviced and/or replaced. Moreover, as the power management circuit is contained within the housing, field replacement of the power management module is enabled. For example, field technician may pull a server tray from the server rack, remove the power management module from a back side, for example, of the server tray (e.g., by unscrewing a few screws), and replace the power management module.

Additionally, at least a portion of the power management module is configured to flex and/or float with respect to a remainder of the server tray. Thus, when the busbar connector is coupled into electrical communication with a busbar, the server tray may move within a range of motion and the busbar connector does not abrade the busbar. For example, when the busbar connector is fixedly and/or rigidly secured to the server tray, movement of the server tray may cause the busbar connector to scrape on the busbar, which, over time, can degrade the performance of the busbar and/or damage the busbar. Thus, the flexing or floating of the at least a portion of the power management module with respect to the remainder of the server tray prevents the busbar connector from abrading the busbar. The busbar connector may be flexible such that the busbar connector is able to move and/or flex with small movements of the tray relative to the busbar. This prevents the busbar connector from damaging the busbar.

Thus, various embodiments provide technical improvements to the fields of server trays, powering server trays, datacenters, and/or related fields.

### Example Server Tray and Power Management Module

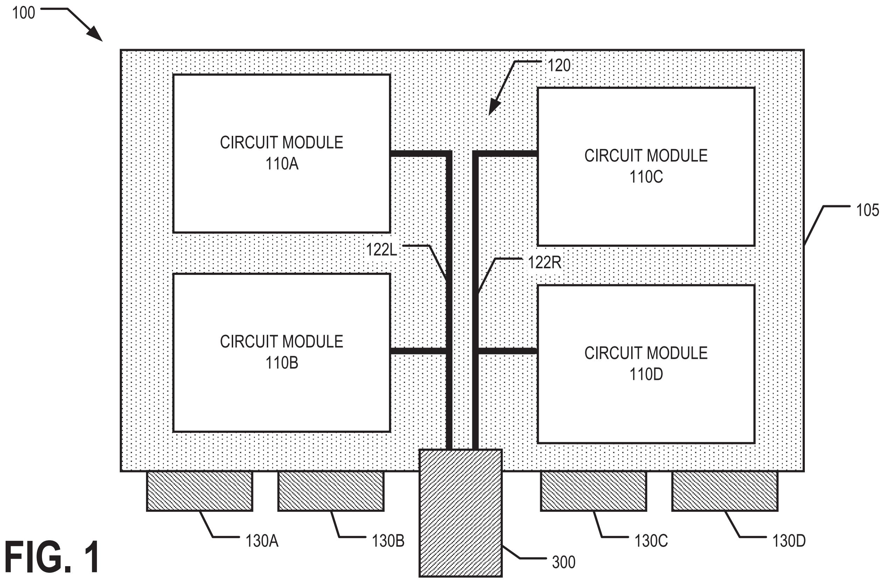

Figure 1 provides a schematic top view of an example server tray 100. The server tray 100 includes a tray component 105. For example, the tray component 105 provides a structure for housing the circuitry components of the server tray 100. The server tray further includes a plurality of circuitry modules 110 (e.g., 110A-110D). In various embodiments, the circuitry modules 110 hosted by the tray component 105 may include one or more of CPUs, PPUs, GPUs, DPUs, QPUs, and/or other processing units; switches; and/or the like.

The server tray 100 may also include a power distribution circuit 120 configured to receive electrical power from the power management module 300 and distribute the electrical power to the circuitry modules 110. In some embodiments, the power distribution circuit 120 comprises two separate circuit portions 122 (e.g., 122L, 122R) that are each configured to provide and/or distribute electrical power to respective (non-overlapping) subsets of the circuitry modules 110. For example, a left circuit portion 122L is configured to provide or distribute electrical power to circuitry modules 110A, 110B disposed on a left side of the server tray 100. A right circuit portion 122R is configured to provide or distribute electrical power to circuitry modules 110C, 110D disposed on a right side of the server tray 100.

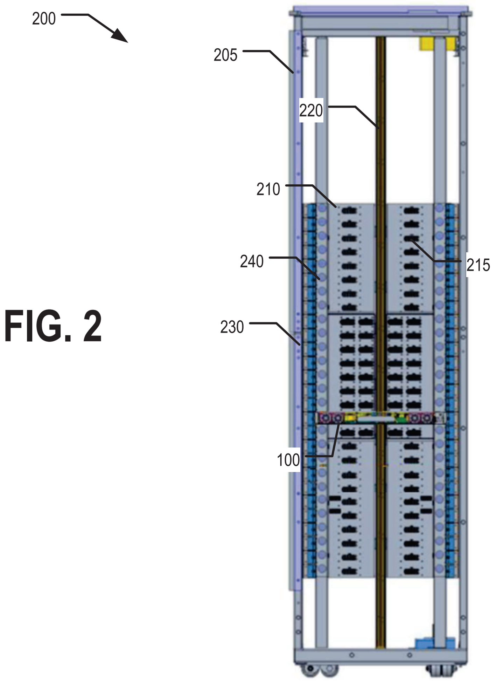

In various embodiments, the server tray 100 further comprises a plurality of cartridge connectors 130 (e.g., 130A-130D). Each cartridge connector is in wired and/or cabled communication with respective circuit modules 110. The cartridge connectors 130 are configured such that, when the server tray 100 is mounted within a rack 205, as shown in Figure 2, the cartridge connectors 130 of the tray are mated with corresponding cartridge connectors 215 of a cable cartridge 210 of the rack 205.

The server tray 100 further comprises a power management module 300. The power management module 300 may be removably secured to the tray component 105. For example, the power management module 300 may be secured to the tray component 105 such that a tray connector of the power management module 300 is placed into electrical communication with the power distribution circuit 120 of the server tray 100. The power management module 300 may be removed and/or disconnected from the tray component 105 without disrupting or affecting the power distribution circuit 120 and/or circuitry modules 110. The same power management module 300 or a new power management module 300 may then be secured to the tray component 105 such that a tray connector of the power management module 300 is placed into electrical communication with the power distribution circuit 120 of the server tray 100. For example, the power management module 300 may comprise a busbar connector configured to be placed into electrical communication with the busbar 220 of a server rack 205 so as to provide electrical power to the power distribution circuit 120 of the server tray 100. In an example embodiment, the server tray 100 and/or the tray component 105 is configured in accordance with Electronic Industries Alliance (EIA) standards.

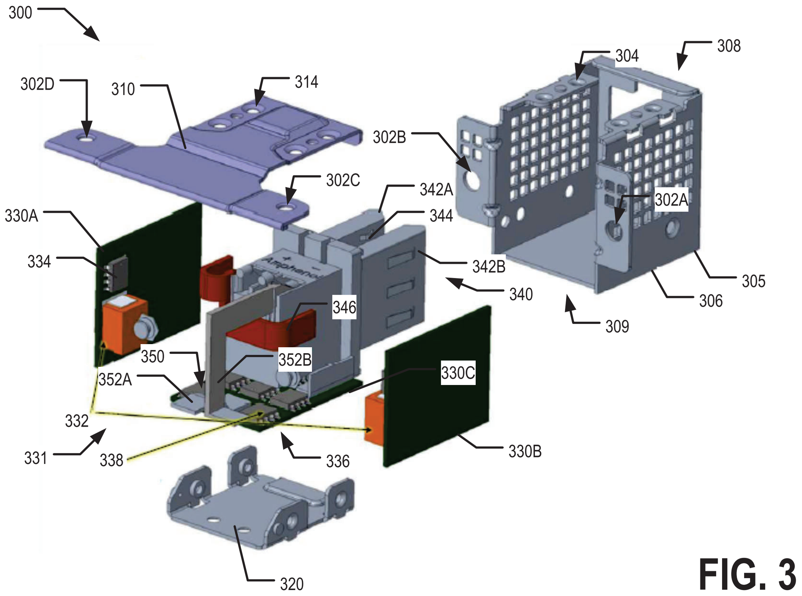

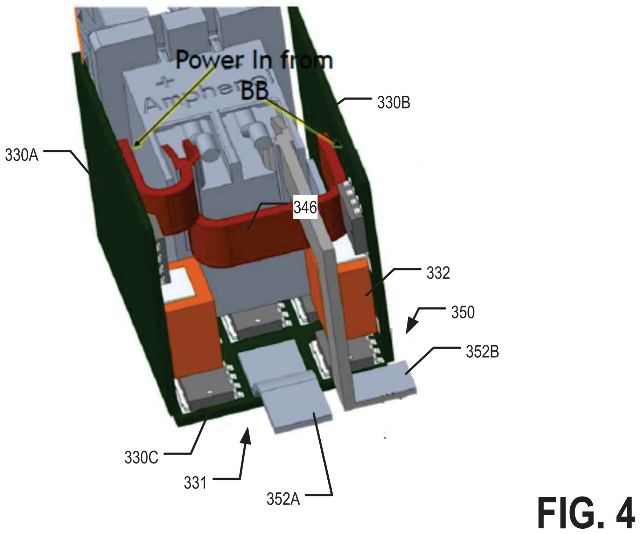

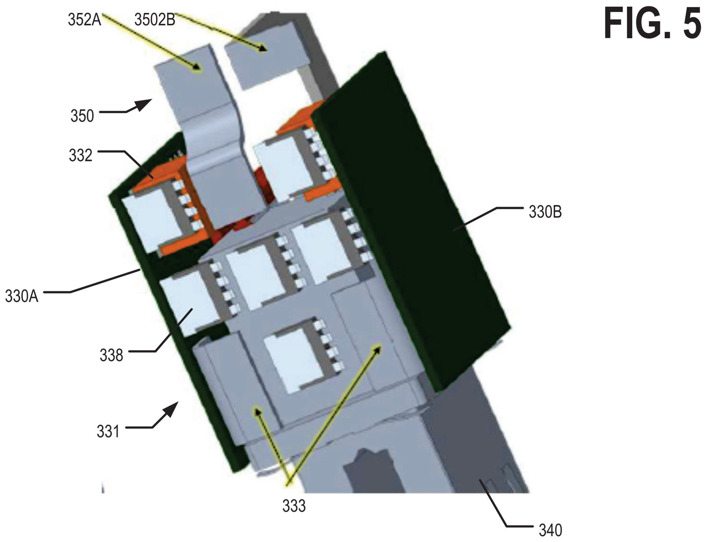

Figures 3, 4, and 5 provide various views of an example embodiment of a power management module 300. Figure 3 provides an exploded perspective view of the power management module 300. Figure 4 provides a front perspective view of the power management module 300. Figure 5 provides a bottom perspective view of the power management module 300 looking through the bottom circuit board 330C (e.g., as if the bottom circuit board 330C was see through).

In various embodiments, a power management module 300 includes a busbar connector 340, a housing 305 housing power management circuitry 331, and a tray connector 350. In various embodiments, the busbar connector 340 extends from a first side 308 of the housing 305. The busbar connector 340 includes a pair of paddles 342A, 342B having contacts 344 disposed therebetween. The busbar connector 340 is configured to receive the busbar 220 (e.g., in accordance with Open Rack Version 3 (ORV3)) between the paddles 342A, 342B such that the busbar 220 is in electrical communication with the contacts 344. In an example embodiment, the contacts 344 extend out from the respective paddles 342 between the pair of paddles 342A, 342B.

In an example embodiment, the paddles 342 and/or the contacts 344 are configured to provide floating electrical connection with the busbar 220. For example, the paddles 342 and/or contacts 344 are configured to enable movement of the busbar connector 340 with respect to the busbar 220 without the busbar connector 340 abrading the busbar 220. For example, the busbar connector 340 may be configured to enable the server tray 100 to move within a movement range without modifying the electrical contact and/or physical contact between the contacts 344 and the busbar 220. For example, at least a portion of the power management module 300 is configured to flex with respect to a remainder of the server tray 100 such that, when the busbar connector 340 is coupled into electrical communication with a busbar 220, flexing of the at least a portion of the power management module 300 with respect to the remainder of the server tray 100 prevents the busbar connector 340 from abrading the busbar 220.

In various embodiments, the housing 305 comprises a cage portion 306, a top portion 310, and a bottom portion 320. In various embodiments, the housing 305 is configured to contain the power management circuitry 331 and provide for cooling of the power management circuitry 331. For example, the cage portion 306 comprises perforated walls configured to enable air movement around the power management circuitry 331. The bottom portion 320 and the top portion 310 are configured to at least partially enclose the power management circuitry 331 within housing 305 and/or to at least partially enable securing the housing 305 to the tray component 105. The top portion 310 and the bottom portion 320 are configured to be secured to the cage portion 306 via mechanical fasteners (e.g., screws) via respective fastener holes 304, 314, for example.

In some embodiments, the housing 305 further houses one or more cooling mechanisms. For example, the housing 305 may be in thermal communication with a cooling system of the server tray 100 to which the power management module 300 is secured. For example, a thermal communication path between a liquid cooling system or an air-cooling system of the server tray 100 may be present to siphon heat away from the power management module 300. In some embodiments, a portion of the housing may be configured to act as at least a portion of a thermal communication path between a cooling system of the server tray 100 and the power management module 300.

In certain embodiments, the power management circuitry 331 comprises circuitry configured to operate at and/or withstand operation at high temperatures. For example, in certain embodiments, the power management circuitry 331 includes at last one of GaN or diamond-based circuitry.

In various embodiments, the power management circuitry 331 is hosted by one or more circuit boards 330 (e.g., 330A-330C). The circuit boards 330 may be PCBs. The circuit boards 330 are configured to be disposed and/or enclosed within the housing 305. In various embodiments, the power management circuitry 331 comprises one or more fuse components 332. In certain embodiments, the one or more fuse components 332 are effuses, however other components configured to function as fuses may be used in other embodiments.

In various embodiments, the power management circuitry 331 comprises one or more hotswap controllers 336 and a plurality of field effect transistors (FETs) 334. In various embodiments, the FETs 334 are configured to receive a first input from a fuse component 332 and second input from a hotswap controller 336. The FETs 334 provide an output that is provided to the tray connector 350 to provide electrical power to the server tray 100. For example, the hotswap controller 336 is configured to control a time evolution of electrical power passing through the plurality of FETs 334. For example, the output of the FETs 334 provided to the tray connector 350 is configured to be a smoothed electrical power that does not include sudden increases or decreases in electrical power provide to the server tray 100 via the tray connector 350. For example, a capacitance, resistance, and/or the like provided via the hotswap controller 336 is configured to smooth the time evolution of electrical power received from the busbar 220 via the busbar connector 340 by smearing or spreading out in time any changes in voltage and/or current in the electrical power provided by the busbar connector 340. For example, the hotswap controller 336 is configured to control inrush current when the busbar connector 340 is placed into electrical communication with the busbar. In some embodiments, the hotswap controller 336 comprises a plurality of metal-oxide-semiconductor field effect transistors (MOSFETs).

In various embodiments, one or more fuse components 332 and respective plurality of FETs 334 are hosted by side circuit boards 330A, 330B. For example, the fuse components 332 and FETs 334 may be in electrical communication with traces of the side circuit boards 330A, 330B. The side circuit boards 330A, 330B are in communication with components hosted by the bottom circuit board 330C (e.g., MOSFETs 338 and/or the like) via board connectors 333. For example, the board connectors 333 may provide electrical connections between traces of the side circuit boards 330A, 330B and traces of the bottom circuit board 330C.

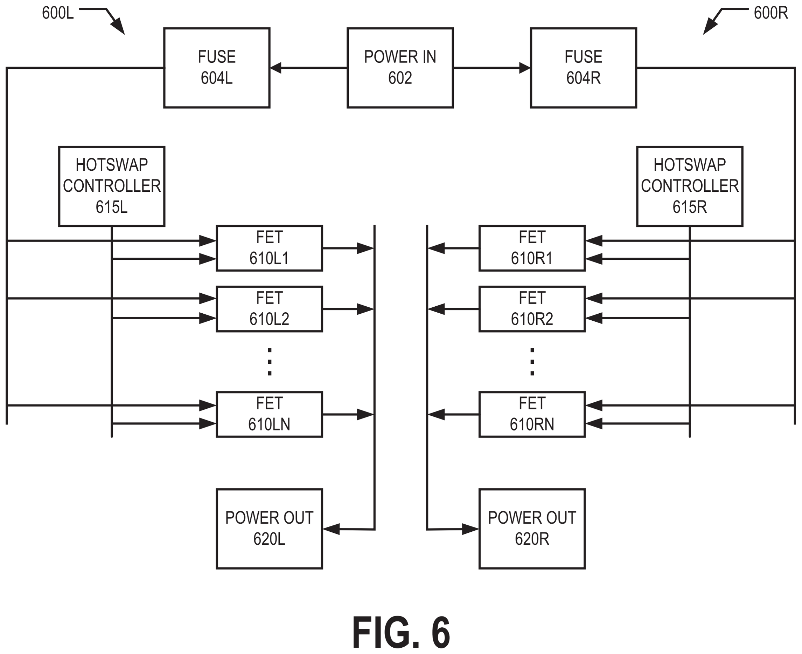

As shown in Figure 6, in some embodiments, the power management circuitry 331 may include at least two parallel power conditioning portions 600 (e.g., 600L, 600R). In some embodiments, the power management circuitry includes at least two parallel power conditioning portions such that each parallel power conditioning portion 600 conditions only a fraction of the electrical power provided to the server tray 100. For example, the electrical power received from the busbar 220 via the busbar connector 340 may be of high voltage and/or current. For example, the voltage and/or current may be too large for conditioning via a single circuitry path. By splitting the electrical power into at least two parallel paths, the electrical power conditioned by each parallel power conditioning portion is reduced by at least a factor of two, compared to the electrical power received from the busbar 220 via the busbar connector 340.

In various embodiments, power in 602 is received by the power management circuitry 331 from the contacts 244 of the busbar connector 340. The power in 602 is split into two parallel power conditioning portions 600 of the power management circuitry 331. In some embodiments the amount of electrical power provided to the first/left parallel power conditioning portion 600L is substantially equal to the amount of electrical power provided to the second/right parallel power conditioning portion 600R.

Each of the parallel power conditioning portions 600 includes a respective fuse component 604 (e.g., 604L, 604R). The fuse component 604 receives a respective portion of the electrical power received by the power management circuitry 331 via the busbar connector 340. In various embodiments, the fuse component 604 is configured to pass the electrical power to a respective plurality of FETs 610. For example, the first/left fuse component 604L provides electrical power to a first/left plurality of FETs 610L1, 610L2, ..., 610LN and the second/right fuse component 604R provides electrical power to a second/right plurality of FETs 610R1, 610R2, ..., 610RN.

In various embodiments, each of the parallel power conditioning portions 600 further includes a hotswap controller 615 (e.g., 615L, 615R). In various embodiments, each of the hotswap controllers 615 is configured to control a time evolution of electrical power passing through the respective plurality of FETs. For example, the first/left hotswap controller 615L is configured to control a time evolution of electrical power passing through the first/left plurality of FETs 610L1, 610L2, ..., 610LN and the second/right hotswap controller 615R is configured to control a time evolution of electrical power passing through the second/right plurality of FETs 610R1, 610R2, ..., 610RN. In various embodiments, a hotswap controller 615 includes a plurality of MOSFETs.

Each FET 610 of a respective plurality of FETs receives a first input from the respective fuse component 604 and the respective hotswap controller 615 and provides a respective output provided as power out 620 (e.g., 620L, 620R). For example, the power out 620 is provided to the tray connector 350.

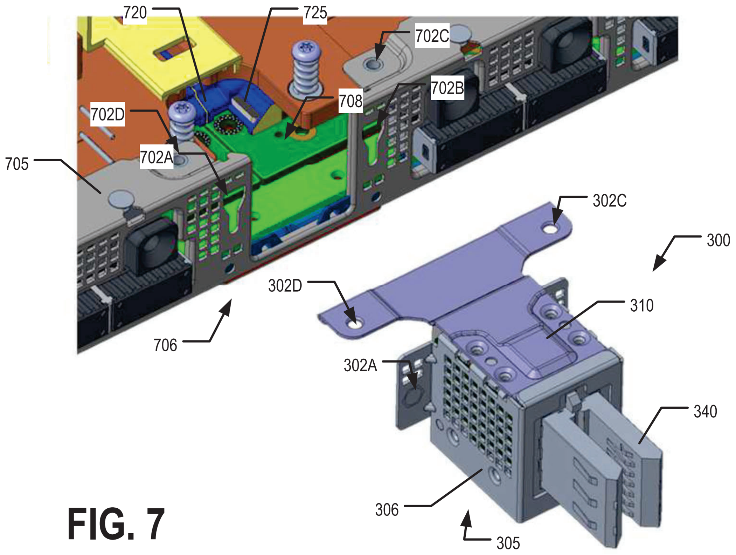

In various embodiments, the tray connector 350 comprises one or more output power pins 352 (e.g., 352A, 352B). In various embodiments, the output power pins 352 are configured to pass electrical power from the power management circuitry 331 to the circuit portions 122 of the power distribution circuit 120. For example, each power pin 352 is configured to be placed into electrical communication with a respective electrical contact (e.g., 725 as shown in Figure 7) of the server tray 100. In an example embodiment, a first power pin 352A receives the first/left power out 620L and provides the first/left power out 620L to first/left circuit portion 122L of the power distribution circuit 120 and a second power pin 352B receives the second/right power out 620R and provides the second/right power out 620R to second/right circuit portion 122R of the power distribution circuit 120. The circuit portions 122 then distribute the electrical power to respective circuit modules 110.

Figure 7 provides a perspective view of a portion of the server tray 100 showing how the power management module 300 can be removably secured to the tray component 705 of a server tray. For example, the power management module 300 may be secured to a back surface or edge 706 of the tray component 705. For example, the back surface or edge 706 may include fastener holes or slots 702A-702D that correspond to the fastener holes 302A-302D of the housing 305. For example, mechanical fasteners (e.g., screws and/or the like) may be used to removably secure the housing 305 to the back surface or edge 706 of the tray component 705 via the fastener holes 302A-302D and the corresponding fastener hole or slots 702A-702D. In some embodiments, the fastener holes or slots 702A-702D are configured to enable movement within a movement range between the tray component 705 and the power management module 300 while maintaining electrical communication between the tray connector 350 and the power distribution circuit 720.

In various embodiments, the housing 305 is removably secured to the back surface or edge 706 of the tray component such that the tray connector 350 extends into the interior of the tray 708. For example, the one or more power pins 352 may extend from the second surface 309 of the housing 305 such that they may extend from the housing 305 into the interior of the tray 708. For example, the one or more power pins 352 may be placed into electrical communication with respective contacts 725 of the power distribution circuit 720.

In various embodiments, a power pin 352 is configured to float with respect to the corresponding contact 725. For example, the housing 305 is removably secured such that each power pin 352 is in electrical communication and/or direct physical contact with a respective contact 725. However, the power pin 352 is not soldered or otherwise secured to the respective contact 725. In some embodiments, the power pins 352 and/or contacts 725 may be configured to be biased toward one another. For example, a power pin 352 and/or the respective contact 725 may be biased so as to press the power pin 352 against the respective contact 725. For example, the power management module 300 may be configured to be removably secured to the back surface or edge 706 of a tray component 705 so as to provide a robust electrical communication between a tray connector 350 of the power management module 300 and a power distribution circuit 720 of the server tray.

### Example Datacenter

Figure 2 illustrates at least a portion of a datacenter 200. The datacenter 200 includes at least one server tray 100 mounted within a rack 205. The track comprises a cable cartridge 210 comprising a plurality of cartridge connectors 215 configured to mate with and/or couple to corresponding cartridge connectors 130 of the server tray 100. The rack 205 further includes a busbar 220 configured to be in electrical communication with the busbar connector 340 to provide electrical power to the server tray 100. In various embodiments, the busbar 220 is configured in accordance with ORV3 standards. The rack 205 further includes a chassis 230 configured to support the server tray 100 and/or provide a structure to which the server tray 100 may be mounted. In an example embodiment, the chassis 230 is configured in accordance with EIA standards. In some embodiments, the rack 205 further includes a liquid cooling manifold 240 configured to be placed into fluid communication with liquid cooling ports of a tray so as to provide liquid cooling of the tray.

In various embodiments, at least one server tray 100 of the datacenter 200 includes a power management module 300. The power management module 300 comprises a busbar connector 340 configured to interface with the busbar 220 of the rack 205. The power management module 300 further includes a tray connector 350 configured to provide electrical power to the server tray 100. For example, the power management module 300 is configured to provide electrical power to power the circuitry modules 110 of the server tray 100. For example, the power management module 300 is configured to provide a self-contained power management system for a server tray 100 that is field replaceable unit.

Datacenters may include multiple network switches in a particular topology, such as a fat tree topology, a slim fly topology, a dragonfly topology, and/or the like. The specifications and makeup of the network switches in the topology affects the overall network performance (e.g., bandwidth capability) of the datacenter.

Datacenters are the storage and data processing hubs of the internet. The massive deployment of cloud applications is causing datacenters to expand exponentially in size, stimulating the development of faster switches than can cope with the increasing data traffic inside the datacenter. Current state-of-the-art switches are capable of handling 12.8 Tb/s of traffic by employing electrical switches in the form of application specific integrated circuits (ASICs) equipped with 256 data lanes, each operating at 50 Gbps. Such switching ASICs typically consume as much as 400 W, and the power consumption of the optical transceiver interfaces attached to each ASIC is comparable. To keep pace with traffic demand, switch capacity doubles approximately every two years. To date, this rapid scaling has been made possible by exploiting advances in manufacturing (e.g., CMOS techniques), collectively described by Moore's law (i.e., the observation that the number of transistors in a dense integrated circuit doubles about every two years). However, in recent years there are strong indications of Moore's law slowing down, which raises concerns about the capability to sustain the target scaling rate of switch capacity. As a result, alternative technologies are being investigated.

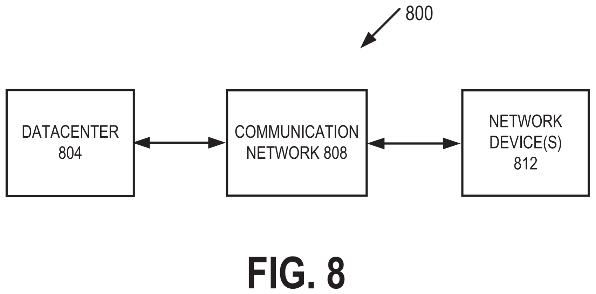

Figure 8 illustrates a system 800 according to at least one example embodiment. The system 800 includes a datacenter 804, a communication network 808, and one or more network devices 812. In at least one example embodiment, the datacenter 804 corresponds to a collection of network devices, such as network switches (e.g., Ethernet switches) connected with a collection of servers or compute nodes. The datacenter 804 may adhere to a networking topology (e.g., a hierarchal networking topology), such as a fat tree topology, a Slim Fly topology, a Dragonfly topology, and/or the like. The datacenter 804 routes traffic amongst the network switches and servers therein, and at least one layer of the topology in the datacenter 804 is coupled to the communication network 808 to allow networking traffic to flow between the datacenter 804 and the network device(s) 812.

Examples of the communication network 808 that may be used to connect the datacenter 804 and the network device(s) 812 include an Internet Protocol (IP) network, an Ethernet network, an InfiniBand (TB) network, a Fibre Channel network, the Internet, a cellular communication network, a wireless communication network, combinations thereof (e.g., Fibre Channel over Ethernet), variants thereof, and/or the like.

The one or more network devices 812 may include switch, router, or Network Interface Controller (NIC), interconnect using ports, one or more of Personal Computer (PC), a laptop, a tablet, a smartphone, a server, a collection of servers, and/or any suitable computing device for sending and receiving signals over the communication network 808. In at least one example embodiment, the one or more network devices 812 correspond to another datacenter, similar to or the same as datacenter 804.

As noted above, the datacenter 804 and/or the network device(s) 812 may include storage devices and/or processing circuitry for carrying out computing tasks, for example, tasks associated with controlling the flow of data internally and/or over the communication network 808. Such processing circuitry may comprise software, hardware, or a combination thereof. For example, the processing circuitry may include a memory including executable instructions and a processor (e.g., a microprocessor) that executes the instructions on the memory. The memory may correspond to any suitable type of memory device or collection of memory devices configured to store instructions. Non-limiting examples of suitable memory devices that may be used include Flash memory, Random Access Memory (RAM), Read Only Memory (ROM), variants thereof, combinations thereof, or the like. In some embodiments, the memory and processor may be integrated into a common device (e.g., a microprocessor may include integrated memory).

Additionally or alternatively, the processing circuitry may comprise hardware, such as an application specific integrated circuit (ASIC). For example, the processor may be or include one or more of an Integrated Circuit (IC) chip, a microprocessor, a Central Processing Unit (CPU), a Graphics Processing Unit (GPU), a Data Processing Unit (DPU), a Field Programmable Gate Array (FPGA), a network interface controller (NIC), an ASIC, combinations thereof, and the like. The processing circuitry may comprise an ASIC and/or may be capable of performing as a central processing unit (CPU), a graphics processing unit (GPU), a network interface controller (NIC), a data processing unit (DPU), or any other computing device in which with data is received and/or transmitted.

Some or all of the processing circuitry may be provided on a Printed Circuit Board (PCB) or collection of PCBs. It should be appreciated that any appropriate type of electrical component or collection of electrical components may be suitable for inclusion in the processing circuitry.

In addition, although not explicitly shown, it should be appreciated that the datacenter 804 and network device(s) 812 may include one or more communication interfaces for facilitating wired and/or wireless communication between one another and other unillustrated elements of the system 800.

In related art systems, a fat tree topology may use the same electrical switching devices on all layers (edge, aggregation, core). For example, each switching device may be 1 U switch, where 1 U refers to the industry standard size for rack-mounted switch and/or server. The interconnection between switches of different layers may be accomplished with optical links or optical interconnects using active optical cables and optical transceivers implemented in a pluggable form factor (also referred to as "pluggables").

Optical Datacenter Networks rely on allocation and deallocation of light paths from the data sources to the destinations end-ports to guarantee no light collisions and data loss occur in the fabric. Traditionally the allocation algorithms are run from a central entity which considers the entire demand for source and destination flows and try to find the most dense mapping of these demands to network resources over a single or multiple time periods.

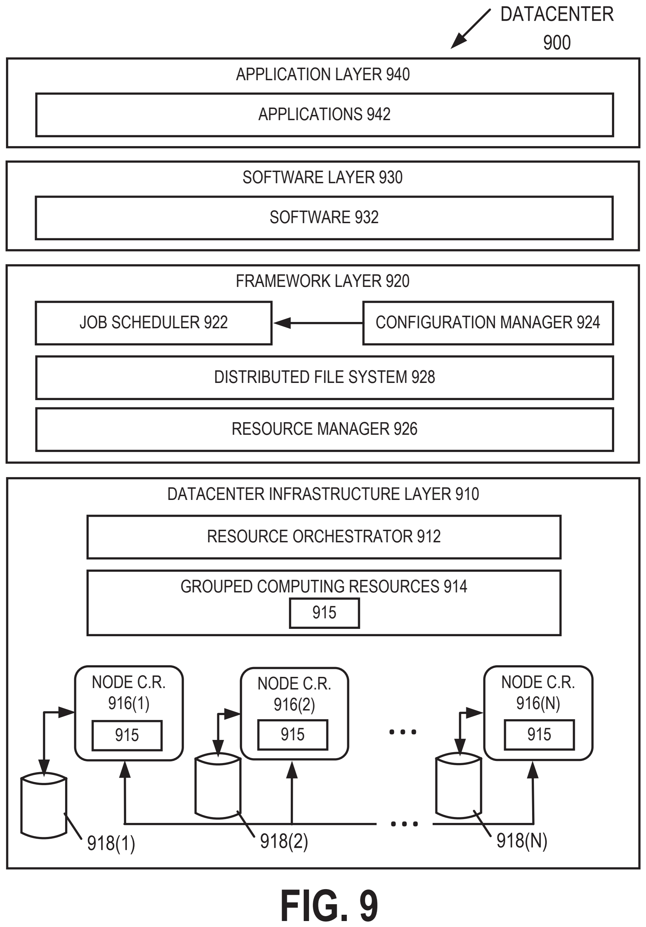

Figure 9 illustrates an example datacenter 900, in which at least one embodiment may be used. In at least one embodiment, datacenter 900 includes a datacenter infrastructure layer 910, a framework layer 920, a software layer 930, and an application layer 940. In various embodiments, the datacenter infrastructure layer 910 may include one or more trays of various embodiments. For example, the node computing resources 919(1)-919(N) may include processing units that are organized into groups on trays of various embodiments. For example, the grouped computing resources 914 may comprise one or more configurable L1 domains.

In at least one embodiment, as shown in Figure 9, datacenter infrastructure layer 910 may include a resource orchestrator 912, grouped computing resources 914, and node computing resources ("node C.R.s") 916(1)-916(N), where "N" represents a positive integer (which may be a different integer "N" than used in other figures). In at least one embodiment, node C.R.s 916(1)-916(N) may include, but are not limited to, any number of central processing units ("CPUs") or other processors (including accelerators, field programmable gate arrays (FPGAs), graphics processors, etc.), memory storage devices 918(1)-918(N) (e.g., dynamic read-only memory, solid state storage or disk drives), network input/output ("NW I/O") devices, network switches, virtual machines ("VMs"), power modules, and cooling modules, etc. In at least one embodiment, one or more node C.R.s from among node C.R.s 916(1)-916(N) may be a server having one or more of above-mentioned computing resources.

In at least one embodiment, grouped computing resources 914 may include separate groupings of node C.R.s housed within one or more racks (not shown), or many racks housed in datacenters at various geographical locations (also not shown). In at least one embodiment, separate groupings of node C.R.s within grouped computing resources 914 may include grouped compute, network, memory, or storage resources that may be configured or allocated to support one or more workloads. In at least one embodiment, several node C.R.s including CPUs or processors may grouped within one or more racks to provide compute resources to support one or more workloads. In at least one embodiment, one or more racks may also include any number of power modules, cooling modules, and network switches, in any combination.

In at least one embodiment, resource orchestrator 912 may configure or otherwise control one or more node C.R.s 916(1)-916(N) and/or grouped computing resources 914. In at least one embodiment, resource orchestrator 912 may include a software design infrastructure ("SDI") management entity for datacenter 900. In at least one embodiment, resource orchestrator 912 may include hardware, software or some combination thereof.

In at least one embodiment, as shown in Figure 9, framework layer 920 includes a job scheduler 922, a configuration manager 924, a resource manager 926 and a distributed file system 928. In at least one embodiment, framework layer 920 may include a framework to support software 932 of software layer 930 and/or one or more application(s) 942 of application layer 940. In at least one embodiment, software 932 or application(s) 942 may respectively include web-based service software or applications, such as those provided by Amazon Web Services, Google Cloud and Microsoft Azure. In at least one embodiment, framework layer 920 may be, but is not limited to, a type of free and open-source software web application framework such as Apache Spark^{™} (hereinafter "Spark") that may utilize distributed file system 928 for large-scale data processing (e.g., "big data"). In at least one embodiment, job scheduler 922 may include a Spark driver to facilitate scheduling of workloads supported by various layers of datacenter 900. In at least one embodiment, configuration manager 924 may be capable of configuring different layers such as software layer 930 and framework layer 920 including Spark and distributed file system 928 for supporting large-scale data processing. In at least one embodiment, resource manager 926 may be capable of managing clustered or grouped computing resources mapped to or allocated for support of distributed file system 928 and job scheduler 922. In at least one embodiment, clustered or grouped computing resources may include grouped computing resources 914 at datacenter infrastructure layer 910. In at least one embodiment, resource manager 926 may coordinate with resource orchestrator 912 to manage these mapped or allocated computing resources.

In at least one embodiment, software 932 included in software layer 930 may include software used by at least portions of node C.R.s 916(1)-916(N), grouped computing resources 914, and/or distributed file system 928 of framework layer 920. In at least one embodiment, one or more types of software may include, but are not limited to, Internet web page search software, e-mail virus scan software, database software, and streaming video content software.

In at least one embodiment, application(s) 942 included in application layer 940 may include one or more types of applications used by at least portions of node C.R.s 916(1)-916(N), grouped computing resources 914, and/or distributed file system 928 of framework layer 920. In at least one embodiment, one or more types of applications may include, but are not limited to, any number of a genomics application, a cognitive compute, application and a machine learning application, including training or inferencing software, machine learning framework software (e.g., PyTorch, TensorFlow, Caffe, etc.) or other machine learning applications used in conjunction with one or more embodiments.

In at least one embodiment, any of configuration manager 924, resource manager 926, and resource orchestrator 912 may implement any number and type of self-modifying actions based on any amount and type of data acquired in any technically feasible fashion. In at least one embodiment, self-modifying actions may relieve a datacenter operator of datacenter 900 from making possibly bad configuration decisions and possibly avoiding underutilized and/or poor performing portions of a datacenter.

In at least one embodiment, datacenter 900 may include tools, services, software, or other resources to train one or more machine learning models or predict or infer information using one or more machine learning models according to one or more embodiments described herein. For example, in at least one embodiment, a machine learning model may be trained by calculating weight parameters according to a neural network architecture using software and computing resources described above with respect to datacenter 900. In at least one embodiment, trained machine learning models corresponding to one or more neural networks may be used to infer or predict information using resources described above with respect to datacenter 900 by using weight parameters calculated through one or more training techniques described herein.

In at least one embodiment, datacenter may use CPUs, application-specific integrated circuits (ASICs), GPUs, FPGAs, or other hardware to perform training and/or inferencing using above-described resources. Moreover, one or more software and/or hardware resources described above may be configured as a service to allow users to train or performing inferencing of information, such as image recognition, speech recognition, or other artificial intelligence services.

Inference and/or training logic 915 are used to perform inferencing and/or training operations associated with one or more embodiments. In at least one embodiment, inference, and/or training logic 915 may be used in system Figure 9 for inferencing or predicting operations based, at least in part, on weight parameters calculated using neural network training operations, neural network functions and/or architectures, or neural network use cases described herein.

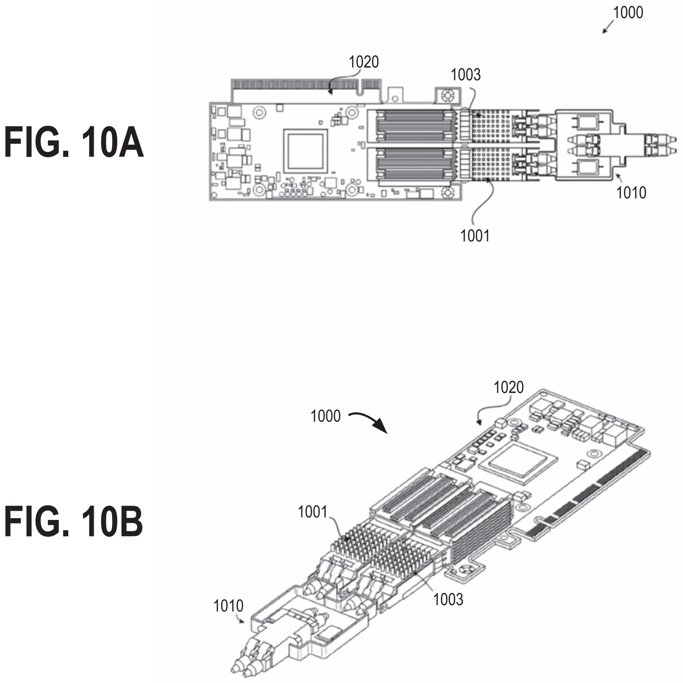

Figures 10A and 10B illustrate a top view and a perspective view, respectively, of a transceiver module operatively coupled to a network adapter, in the present example a Network Interface Controller (NIC) 1000, in accordance with an embodiment of the disclosure. As shown in FIGS. 10A and 10B, the transceiver module may include a first optical module 1001, a second optical module 1003, an adapter 1010, and a dual-port NIC 1020 of a server. Both the first optical module 1001 and the second optical module 1003 may be dual-fiber transceivers that are configured for duplex communication that allows the source (e.g., server) to communicate with the target (e.g., leaf switch) in both directions. The adapter 1010 may be a ganged physical component configured to link the first optical module 1001 and the second optical module 1003 for the purpose of transmitting and receiving data to and from the leaf switch.

In some embodiments, the adapter 1010 may be configured to operate in two configurations, such as a first configuration and a second configuration. In one aspect, the first configuration may be a default configuration of operation, where the first optical module 1001 may be operationally active. The second configuration may be a contingent configuration that is implemented when the first optical module 1001 operationally fails. When such a failure is detected, the second optical module 1003, which is otherwise operationally inactive or idle, may be engaged become operationally active and handle all network traffic that was initially handled by the first optical module 1001.

In some embodiments, the transceiver module 1000 may be configured to operate in a leaf-spine architecture. A leaf-spine architecture is a data center network topology that may include two switching layers-a spine layer and a leaf layer. The leaf layer may include access switches (leaf switches) that aggregate traffic from servers and connect directly into the spine or network core. Spine switches interconnect all leaf switches in a full-mesh topology between access switches in the leaf layer and the servers from which the access switches aggregate traffic. As such, in one embodiment, to ensure reliable operation of downlinks, the transceiver module 1000 may be configured to operate between the server and the leaf layer. In particular, as shown in FIGS. 10A and 10B, the adapter 1010 may be operatively coupled to the first optical module 1001 and the second optical module 1003, while the first optical module 1001 and the second optical module 1003 may be operatively coupled to a dual-port NIC 1020 of a server.

In embodiments, NIC 1020 may comprise one or more processing circuits, as detailed above; the processing circuits may comprise FW, that is loaded according to the techniques described above.

### Example System Use Case

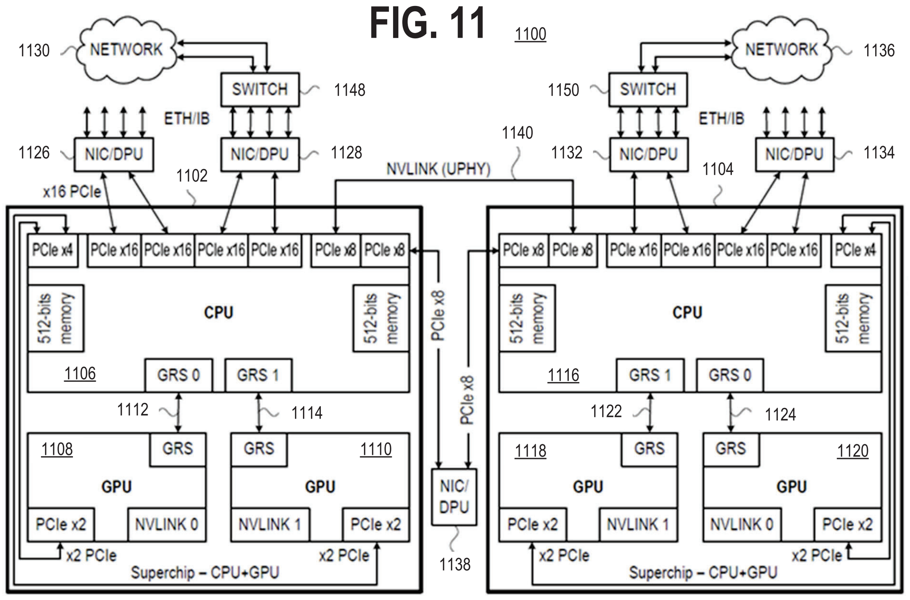

Figure 11 is a block diagram that schematically illustrates a computing system 1100, e.g., a data center or a High-Performance Computing (HPC) cluster, in accordance with an embodiment that is described herein. System 1100 comprises a plurality of subsystems, e.g., multiple processing devices coupled to each other, multiple network devices, and multiple networks, according to at least one embodiment. Computing system 1100 is designed with multiple integrated circuits (referred to as processing devices), where each integrated circuit can include one or more CPUs and GPUs, forming a powerful and flexible architecture.

The various processing devices are interconnected via an NVLink or other high-speed interconnect, enabling high-speed communication between the subsystems, and are also connected through a NIC or DPU to ensure efficient data transfer across computing system 1100 and to one or more external networks 1130, 1136. In the present example, system 1100 comprises a packet switch 1148 that connects NIC/DPU 1128 to network 1130, and a packet switch 1150 that connects NIC/DPU 1132 to network 1136.

The coupling of processing devices through NVLink allows for seamless data exchange and parallel processing, enhancing overall computational performance. The processing devices are connected to multiple networks through one or more network interface controllers (NICs) or DPUs, enabling the system to handle complex, multi-network tasks with high bandwidth and low latency. This configuration is highly suitable for demanding applications that require significant processing power, such as artificial intelligence (AI), machine learning (ML), and data-intensive computing, while ensuring robust connectivity and scalability across various networked environments. The integrated circuits of the computing system 1100 can include one or more CPUs and one or more GPUs.

Figure 11 also demonstrates an example architecture of a multi-GPU architecture. As illustrated in the figure, computing system 1100 includes a processing device 1102 with a multi-GPU architecture. In particular, processing device 1102 may be a system-on-chip and includes multiple subsystems such as a CPU 1106, a GPU 1108, and a GPU 1110. CPU 1106 can be coupled to GPU 1108 via a die-to-die (D2D) or chip-to-chip (C2C) interconnect 1112, such as a Ground-Referenced Signaling interconnect (GRS interconnect). CPU 1106 can be coupled to GPU 1110 via a D2D or C2C interconnect 1114. CPU 1106 can also couple to GPU 1108 and GPU 1110 via PCIe interconnects.

CPU 1106 can be coupled to one or more NICs or DPUs, which are coupled to one or more networks. For example, as illustrated in Fig. 3, CPU 1106 is coupled to a first NIC/DPU 1126, which is coupled to a network 1130. CPU 1106 is also coupled to a second NIC/DPU 1128, which is coupled to network 1130 via switch 1148. NIC/DPU 1126 and NIC/DPU 1128 can be coupled to network 1130 over Ethernet (ETH), NVLINK or InfiniBand (IB) connections, for example.

Computing system 1100 also includes a processing device 1104 with a multi-GPU architecture. In particular, processing device 1104 includes multiple subsystems including a CPU 1116, a GPU 1118, and a GPU 1120. CPU 1116 can be coupled to GPU 1118 via an D2D or C2C interconnect 1122. CPU 1116 can be coupled to GPU 1120 via a D2D or C2C interconnect 1124. CPU 1116 can also couple to GPU 1118 and GPU 1120 via PCIe interconnects. CPU 1116 can be coupled to one or more NICs or DPUs, which are coupled to one or more networks. For example, as illustrated in Fig. 3, CPU 1116 is coupled to a first NIC/DPU 1132, which is coupled to a network 1136. CPU 1116 is also coupled to a second NIC/DPU 1134, which is coupled to network 1136 via switch 1150. NIC/DPU 1132 and NIC/DPU 1134 can be coupled to network 1136 over Ethernet (ETH), NVLINK or InfiniBand (IB) connections.

In at least one embodiment, processing device 1102 and processing device 1104 can communication with each other via a NIC/DPU 1138, such as over PCIe interconnects. Processing device 1102 and processing device 1104 can also communicate with each other over a high-bandwidth communication interconnects 1140, such as an NVLink interconnect or other high-speed interconnects. The packet switches in Fig. 11 may comprise, for example, Nvidia Quantum-2 switches. The NICs/DPUs in the figure may comprise, for example, Nvidia Bluefield DPUs.

In various embodiments, one or more of the interconnects 1112, 1114, 1122, 1124 may be optical interconnects disclosed herein. Additionally, in various embodiments, switches 1148, 1150 may be in communication with NIC/DPU 1128, 1132, respectively, via one or more optical interconnects disclosed herein. In some embodiments, NIC/DPU 1126, 1134 may be in communication with one or more additional elements via optical interconnects disclosed herein. For example, various elements of the computing system 1100 may be in communication with one another via one or more optical interconnects disclosed herein.

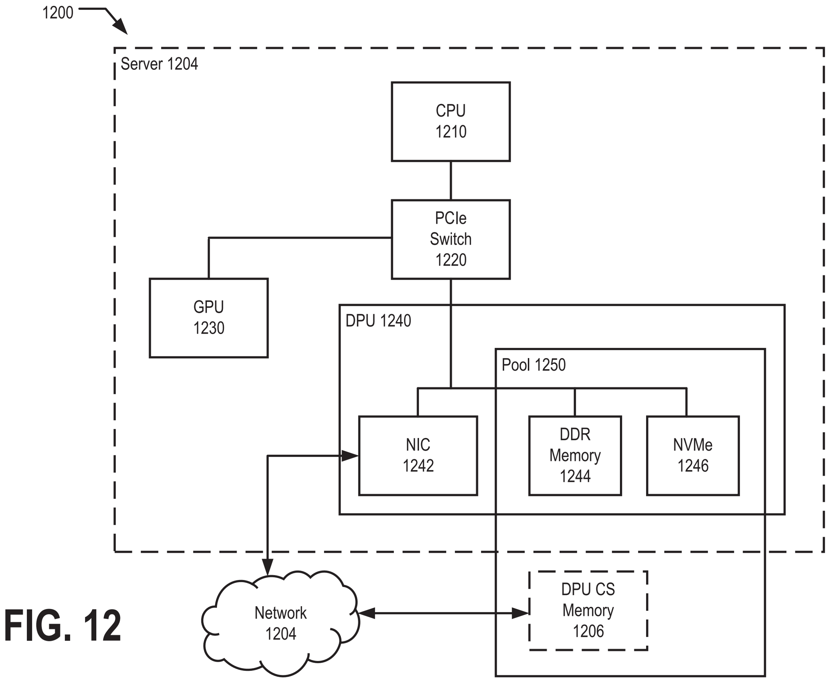

FIG. 12 illustrates an example computing environment 1200 in which forward pass offloading to available memory can be performed, in accordance with at least one embodiment. It should be appreciated that embodiments of the present disclosure may also be used with reference to alternative environments and that specific discussion of components may be provided by way of non-limiting example and may include equivalents. Moreover, various features have been removed for clarity and conciseness. Additionally, systems and methods may be used with a variety of different architectures. The example computing environment 1200 may include a server 1202 which may be used to perform high performance computing (HPC) workloads, such as AI training or machine learning model training. In an embodiment, the server 1202 may be an application instance or a compute node. The server 1202 may include a CPU 1210 associated with a switch 1220, such as a peripheral component interconnect express (PCIe) switch, which may control at least some data transmission over communication paths interconnecting various components. In an embodiment, the CPU 1210 may include a root complex processor.

The PCIe switch 1220 may also be associated with a GPU 1230 and a DPU 1240, and may transmit data between at least some of the CPU 1210, the GPU 1230, the DPU 1240, and other components (e.g., via one or more optical interconnects disclosed herein). In an embodiment, the PCIe switch 1220 may be associated with more than one GPU or more than one DPU. In another embodiment, the PCIe switch 1220 may be located within the DPU 1240. The PCIe switch 1220 may manage the transfer of at least some data between the CPU 1210, the GPU 1230, and the DPU 1240. In another embodiment, the number of GPUs associated with the PCIe switch 1220 may be equal to the number of DPUs associated with the PCIe switch 1220. In at least one embodiment, the server 1202 may include, without limitation, any number of the CPUs 1210, the PCIe switches 1220, the GPUs 1230, and/or the DPUs 1240, in any combination. For example, in at least one embodiment, server 1202 could include eight, sixteen, thirty-two, and/or more GPUs 1230. In at least one embodiment, communication paths interconnecting various components, including but not limited to the CPU 1210, the PCIe switch 1220, the GPU 1230, and the DPU 1240, in FIG. 12 may be implemented using any suitable protocols, such as peripheral component interconnect (PCI) based protocols (e.g., PCIe), or other bus or point-to-point communication interfaces and/or protocol(s), such as NV-Link high-speed interconnect, or interconnect protocols.

The DPU 1240 may include a network interface controller (NIC) 1242, a DDR memory 1244, and a non-volatile memory express (NVMe) device 1246. The NIC 1242 may be able to interface with a network 1204, which may also interface with additional NVMe devices available to the DPU 1240, such as over fabric. In an embodiment, the DPU 1240 may not include the NVMe device 1246. In another embodiment, the NVMe device 1246 may be located on the server 1202 and not on the DPU 1240. In yet another embodiment, the computing environment 1200 may include more than one of the NVMe device 1246, such as a first NVMe device in the DPU 1240 and a second first NVMe device on the server 1202 an associated directly with the PCIe switch 1220. In an embodiment, the DPU 1240 may not include the DDR memory 1244 and may include a computational storage services (CSS) in place of, or in addition to, the DDR memory 1244. For example, computing environment 1200 may include DPU computational storage (CS) memory 1206 available to the DPU 1240 as part of the CSS. The network 1204 may be able to interface with the DPU CS memory 1206 through the NIC 1242, according to any suitable interface protocol, such as remote direct memory access (RDMA) over Ethernet, InfiniBand, Fiber Channel, etc.

The total memory of the computing environment 1200 available for data storage may be expanded through the use of the DPU 1240 on nodes of the system. The DPU 1240 may have access to a pool 1250 of memory already available to the server 1202, such as double data rate (DDR) memory, on-board NVMe devices, NVMe devices over fabric, and CS. The pool 1250 of memory may include at least one of the DDR memory 1244, NVMe 1246, and the DPU CS memory 1206. The DPU 1240 may also be able to access the available memory of other DPUs as part of the pool 1250, and other DPUs may be able to access the available memory of DPU 1240, such as the pool 1250 . This available memory can be accessed and utilized for data storage, without the addition of compute resources, such as compute nodes, which would be required using other solutions. The available pool 1250 accessible to the DPU 1240 may be provisioned for the server 1202 to expand the total memory available for data storage, such as to reduce the data storage load on the CPU 1210 or the GPU 1230, which can instead increase the utilization of their memory for processing. For example, during training of an AI, the model states, residual states, activation functions, and checkpoints can be stored, or offloaded, on the pool 1250 accessible to the DPU 1240.

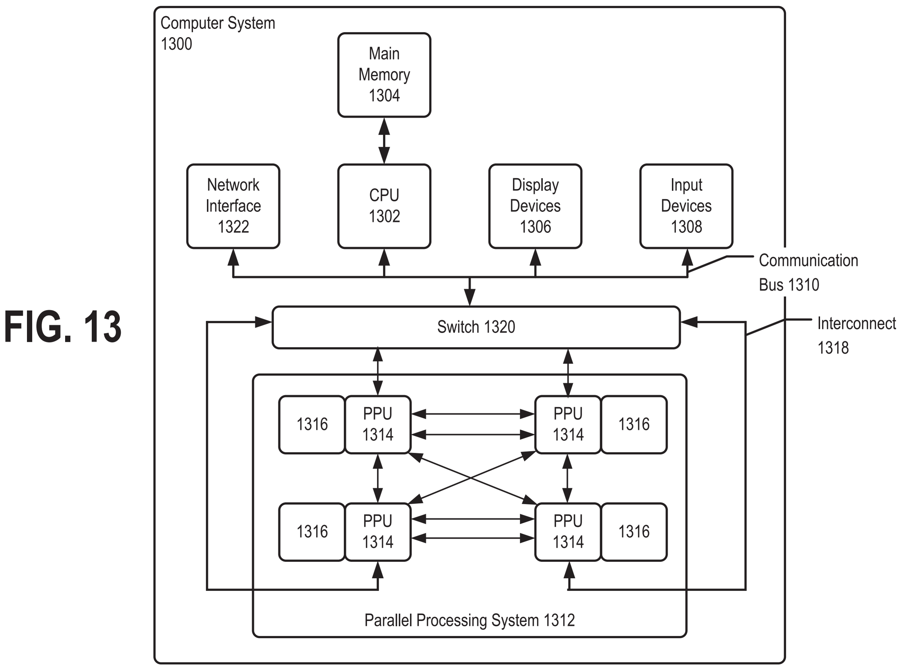

FIG. 13 illustrates a computer system 1300, according to at least one embodiment. In at least one embodiment, computer system 1300 comprises at least one optical interconnect of an example embodiment.

In at least one embodiment, computer system 1300 comprises, without limitation, at least one central processing unit ("CPU") 1302 that is connected to a communication bus 1310 implemented using any suitable protocol, such as PCI ("Peripheral Component Interconnect"), peripheral component interconnect express ("PCI-Express"), AGP ("Accelerated Graphics Port"), HyperTransport, or any other bus or point-to-point communication protocol(s). In at least one embodiment, computer system 1300 includes, without limitation, a main memory 1304 and control logic (e.g., implemented as hardware, software, or a combination thereof) and data are stored in main memory 1304 which may take form of random access memory ("RAM"). In at least one embodiment, a network interface subsystem ("network interface") 1322 provides an interface to other computing devices and networks for receiving data from and transmitting data to other systems from computer system 1300.

In at least one embodiment, computer system 1300, in at least one embodiment, includes, without limitation, input devices 1308, parallel processing system 1312, and display devices 1306 which can be implemented using a conventional cathode ray tube ("CRT"), liquid crystal display ("LCD"), light emitting diode ("LED"), plasma display, or other suitable display technologies. In at least one embodiment, user input is received from input devices 1308 such as keyboard, mouse, touchpad, microphone, and more. In at least one embodiment, each of foregoing modules can be situated on a single semiconductor platform to form a processing system.

In at least one embodiment, computer programs in form of machine-readable executable code or computer control logic algorithms are stored in main memory 1304 and/or secondary storage. Computer programs, if executed by one or more processors, enable system 1300 to perform various functions in accordance with at least one embodiment. memory 1304, storage, and/or any other storage are possible examples of computer-readable media. In at least one embodiment, secondary storage may refer to any suitable storage device or system such as a hard disk drive and/or a removable storage drive, representing a floppy disk drive, a magnetic tape drive, a compact disk drive, digital versatile disk ("DVD") drive, recording device, universal serial bus ("USB") flash memory, etc. In at least one embodiment, architecture and/or functionality of various previous figures are implemented in context of CPU 1302; parallel processing system 1312; an integrated circuit capable of at least a portion of capabilities of both CPU 1302; parallel processing system 1312; a chipset (e.g., a group of integrated circuits designed to work and sold as a unit for performing related functions, etc.); and any suitable combination of integrated circuit(s).

In at least one embodiment, architecture and/or functionality of various previous figures are implemented in context of a general computer system, a circuit board system, a game console system dedicated for entertainment purposes, an application-specific system, and more. In at least one embodiment, computer system 1300 may take form of a desktop computer, a laptop computer, a tablet computer, servers, supercomputers, a smart-phone (e.g., a wireless, hand-held device), personal digital assistant ("PDA"), a digital camera, a vehicle, a head mounted display, a hand-held electronic device, a mobile phone device, a television, workstation, game consoles, embedded system, and/or any other type of logic.

In at least one embodiment, parallel processing system 1312 includes, without limitation, a plurality of parallel processing units ("PPUs") 1314 and associated memories 1316. In at least one embodiment, PPUs 1314 are connected to a host processor or other peripheral devices via an interconnect 1318 and a switch 1320 or multiplexer. In at least one embodiment, parallel processing system 1312 distributes computational tasks across PPUs 1314 which can be parallelizable-for example, as part of distribution of computational tasks across multiple graphics processing unit ("GPU") thread blocks. In at least one embodiment, memory is shared and accessible (e.g., for read and/or write access) across some or all of PPUs 1314, although such shared memory may incur performance penalties relative to use of local memory and registers resident to a PPU 1314. In at least one embodiment, operation of PPUs 1314 is synchronized through use of a command such as_syncthreads( ), wherein all threads in a block (e.g., executed across multiple PPUs 1314) to reach a certain point of execution of code before proceeding.

The PPUs 1314 may be in communication with one another and/or switch 1320 via one or more optical interconnects in accordance with example embodiments disclosed herein.

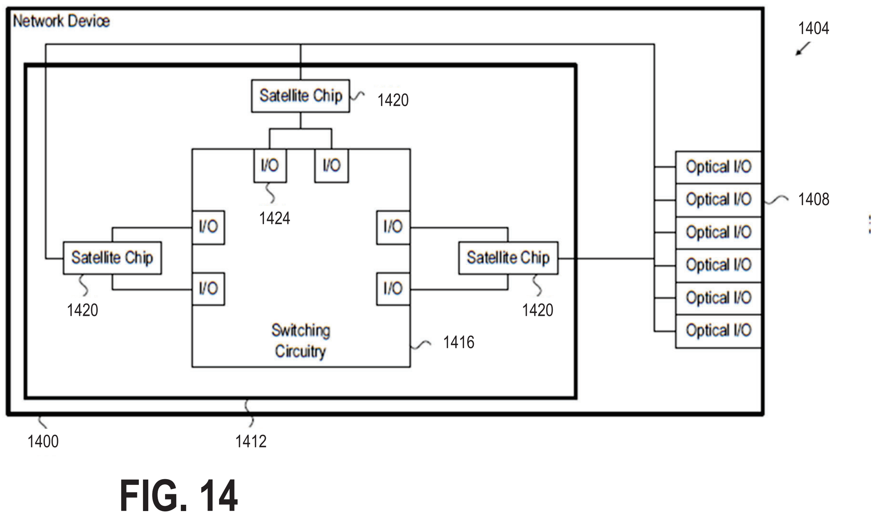

Co-packaging may refer to the close integration of different electrical and/or optoelectronic chips in the same package. Fig. 14 is a block diagram that schematically illustrates a co-packaged Networking Device 1400, in accordance with an embodiment that is disclosed herein. The different chips that constitute a co-packaged Networking Device are assembled on a single substrate in what is typically called the MCM assembly 1412. The MCM assembly 1412 can include a switching circuitry 1416 surrounded by peripheral or satellite chips 1420. In some embodiments, the switching circuitry 1416 and surrounding satellite chips 1420 are all mounted on a common substrate, although such a configuration is not required. The MCM assembly 1412 may be provided in a larger housing of the networking device 1400, positioned behind the front panel 1404. The switching circuitry 1416 may include one or more core digital Application Specific Integrated Circuits (ASICs), CPUs, GPUs, microprocessors, FPGAs, combinations thereof, and the like. The switching circuitry 1416 may include a number of input ports and/or output ports 1428. The Input/Output (I/O) ports 1424 may include electrical ports and/or optical ports. Additionally, the switching circuitry 1416 may include a combination of electrical blocks and optical blocks. The electrical blocks of the switching circuitry 1416 may include a number of electrical switches that are configured to route signals in an electrical domain. The optical blocks of the switching circuitry 1416 may include a number of optical components that are configured to generate, detect, and route signals in an optical domain. The MCM assembly 1412, in some embodiments, may concern or include multiple satellite chips 1420 that are assembled on the same substrate as the switching circuitry 1416. In some embodiments, a configuration of the optical block(s) and a configuration of the electrical block(s) depends (e.g., is based on) on the number of optical ports in the I/O ports 1424.

As discussed above, optical I/Os 1408, which may also be referred to as optical connectors, are placed at the front panel 1404. As mentioned above, connectivity between the MCM assembly 1412 and optical I/Os 1408 may be transferred to the front panel 1404 through optical fibers. This connection may be made directly with an optical I/O 1424 of the switching circuitry or may be made with one or more of the satellite chips 1420. The connection is often made with one or more of the satellite chips 1420 because the satellite chips 1420 may include the electro-optic converters and, possibly, the serializer/deserializer (SERDES) to natively support the connection. The satellite chips 1420 may include one or more of aDSP processor, driver, trans-impedance amplifier, laser, modulator, photodiode, serializer-deserializer, or the like.

Some embodiments of the present disclosure are directed to a multi-chip module (MCM) with a centrally positioned main die and a plurality of peripherally positioned MCM sockets configured to mechanically receive and electrically connect mezzanine packages, which may include co-packaged optics (CPO) packages and co-packaged copper (CPC) packages. Each mezzanine package may include a package substrate including a connector portion that is configured to engage the MCM socket and a main portion extending beyond the periphery of the MCM substrate. The main portion of the mezzanine package may be configured to receive optical devices and/or integrated circuits, such as via mezzanine sockets, to allow connections to be made between the optical devices and/or integrated circuits/RF copper cable connectors and the main die of the MCM. Due to the extension of the mezzanine package beyond the periphery of the MCM substrate, the physical size of the MCM substrate may remain small to reduce cost and avoid the previously discussed production challenges, while allowing connections to a number of optical devices and integrated circuits via the mezzanine packages, which occupy the relatively inexpensive space around the periphery of the MCM substrate. As used herein, the terms "co-packaged optic" (or "CPO") and "co-packaged copper" (or "CPC") may refer to an advanced heterogeneous integration of either optics and silicon or copper and silicon, in which either integration may be implemented on a single packaged substrate. The CPO may utilize pluggable optical modules that include an optical engine (OE) to convert optical signals to electrical signals and electrical signals to optical signals. The CPO may further be comprised of an optical component on a photonics die and an electrical component on an electrical die.

As used herein, a ball grid array (BGA) may be a type of surface-mount packaging used for integrated circuits. BGA packages use an array of metallic conductor balls arranged in a grid to permanently mount devices such as microprocessors on a PCB. The metallic conductor balls may then undergo the reflow process described above, wherein the metallic conductor balls may be preheated, then melted to bond the IC to a substrate to form an IC package.

As used herein, the term "flip chip (FC)" may refer to a method for interconnecting dies, such as semiconductor devices, IC chips, integrated passive devices, and microelectromechanical systems (MEMS), to external circuitry with solder bumps that have been deposited onto chip pads. The solder bumps may be deposited onto chip pads on the top side of the wafer during final wafer processing. The chip may be mounted to external circuitry (such as a circuit board or another chip or wafer) by "flipping" the chip, such that the chip's top side faces down and is positioned to allow the pads of the chip to align with matching pads on the external circuit. Solder is reflowed to complete the interconnect.

### Conclusion

Many modifications and other embodiments will come to mind to one skilled in the art to which this disclosure pertains having the benefit of the teachings presented in the foregoing descriptions and the associated drawings. Therefore, it is to be understood that the disclosure is not to be limited to the specific embodiments disclosed and that modifications and other embodiments are intended to be included within the scope of the appended claims. Although specific terms are employed herein, they are used in a generic and descriptive sense only and not for purposes of limitation.

It will be understood that aspects and embodiments are described above purely by way of example, and that modifications of detail can be made within the scope of the claims.

Each apparatus, method, and feature disclosed in the description, and (where appropriate) the claims and drawings may be provided independently or in any appropriate combination.

Reference numerals appearing in the claims are by way of illustration only and shall have no limiting effect on the scope of the claims.

## Claims

1. A power management module configured for powering a server tray, the power management module comprising:
a housing;
a busbar connector extending from a first side of the housing;
power management circuitry comprising at least one fuse component, the power management circuitry in electrical communication with the busbar connector; and
a tray connector accessible via a second side of the housing, wherein the tray connector is configured to provide electrical power to the server tray.

2. The power management module of claim 1, wherein the tray connector comprises at least one output power pin configured to interface with a power distribution circuit of a tray.

3. The power management module of claim 1 or 2, wherein the power management circuitry comprises at least two parallel power conditioning portions.

4. The power management module of claim 3, wherein the at least one fuse component comprises at least two fuses and each parallel power conditioning portion of the at least two parallel power conditioning portions comprises a hotswap controller and a plurality of field effect transistors (FETs).

5. The power management module of claim 4, wherein each of the plurality of FETs of the parallel power conditioning portion are configured to receive a first input from a fuse of the at least two fuses and a second input from the hotswap controller and configured to provide an output provided to an output power pin of the tray connector.

6. The power management module of claim 4 or 5, wherein the hotswap controller is configured to control a time evolution of electrical power passing through the plurality of FETs.

7. The power management module of claim 6, wherein the hotswap controller comprises one or more metal-oxide-semiconductor field effect transistors (MOSFETs).

8. The power management module of claim 1, wherein the power management circuitry comprises at last one of GaN or diamond-based circuitry.

9. A server tray comprising:
one or more circuit modules; and
a power management module, the power management module comprising:
a housing;
a busbar connector extending from a first side of the housing;
power management circuitry comprising at least one fuse component, the power management circuitry in electrical communication with the busbar connector; and
a tray connector accessible via a second side of the housing, wherein the tray connector is configured to provide electrical power to the server tray,
wherein the one or more circuit modules are powered by the power management module.

10. The server tray of claim 9, further comprising a tray component, wherein the one or more circuit modules are hosted by the tray component and the housing of the power management module is secured to the tray component.

11. The server tray of claim 9 or 10, wherein at least a portion of the power management module is configured to flex with respect to a remainder of the server tray such that, when the busbar connector is coupled into electrical communication with a busbar, flexing of the at least a portion of the power management module with respect to the remainder of the server tray prevents the busbar connector from abrading the busbar.

12. The server tray of claim 9, 10, or 11, wherein the tray connector comprises at least one output power pin configured to interface with a power distribution circuit of the server tray.

13. The server tray of claim 12, wherein the at least one output power pin is in floating physical contact with a contact of the power distribution circuit of the server tray.

14. The server tray of any of claims 9-13, wherein the power management circuitry comprises at least two parallel power conditioning portions which are each configured to power respective subsets of the one or more circuit modules.

15. A datacenter comprising:
one or more server trays, wherein at least one server tray of the one or more server trays comprises:
one or more circuit modules; and
a power management module, the power management module comprising:
a housing;
a busbar connector extending from a first side of the housing;
power management circuitry comprising at least one fuse component, the power management circuitry in electrical communication with the busbar connector; and
a tray connector accessible via a second side of the housing,
wherein the tray connector is configured to provide electrical power to the at least one server tray,
wherein the one or more circuit modules are powered by the power management module.
